# FASCICULE DE BREVET EUROPEEN

(11) **EP 3 238 254 B1**
(45) Date de publication et mention de la délivrance du brevet: **30.06.2021**
(21) Numéro de dépôt: 15817203.1
(22) Date de dépôt: 16.12.2015
(51) Int. Cl.: H01L 27/146

(54) **CAPTEUR D'IMAGE EN COULEURS AVEC PIXELS BLANCS ET PIXELS COLORES**
FARBBILDSENSOR MIT WEISSEN PIXELN UND FARBPIXELN
COLOUR IMAGE SENSOR WITH WHITE PIXELS AND COLOUR PIXELS

(30) Priorité: 22.12.2014 FR 1463121
(43) Date de publication de la demande: 01.11.2017
(73) Titulaire: Teledyne E2V Semiconductors SAS, 38120 Saint-Egrève (FR)
(72) Inventeur: FEREYRE, Pierre, 38340 Voreppe (FR); MAYER, Frédéric, 38500 Voiron (FR); DOUINE, Pascal, 38500 Voiron (FR); LIGOZAT, Thierry, 38950 Quaix-en-Chartreuse (FR); PREVOST, Vincent, 38180 Seyssins (FR); DIASPARRA, Bruno, 38180 Seyssins (FR)
(74) Mandataire: Marks & Clerk France
(86) Numéro de dépôt international: PCT/EP2015/080004
(87) Numéro de publication internationale: WO 2016/102267

(56) Documents cités:
- EP-A1- 0 605 898
- EP-A1- 1 630 871
- US-A1- 2005 173 742
- None

## Description

L'invention concerne les capteurs d'image électronique en couleurs comportant une matrice de pixels photosensibles mesurant la quantité de lumière qu'ils reçoivent. Les capteurs les plus répandus étaient à l'origine des capteurs en technologie CCD et sont de plus en plus souvent des capteurs à pixels actifs en technologie MOS. On décrira l'invention à propos de pixels actifs en technologie MOS.

Un pixel actif en technologie MOS comporte en général une photodiode en silicium et plusieurs transistors permettant de détecter une quantité de charges électriques engendrées dans la photodiode sous l'effet de l'éclairement. Le niveau de signal détecté dans le pixel est transféré à l'extérieur de la matrice vers des circuits de lecture, par exemple un circuit de lecture par colonne de pixels, la lecture étant effectuée ligne par ligne en parallèle sur les différentes colonnes.

Pour la prise d'image en couleurs avec une seule matrice de pixels, on prévoit généralement de déposer au-dessus des pixels, du côté entrant de la lumière, une mosaïque de filtres de couleurs différentes, le plus souvent une mosaïque dite de Bayer comportant un arrangement régulier de groupes de quatre filtres colorés de couleurs primaires qui sont un filtre rouge, un filtre bleu et deux filtres verts. Des arrangements avec des filtres de couleurs secondaires complémentaires cyan, magenta, et jaune, sont aussi possibles. Voir par exemple US 2005/0173742.

Les filtres sont réalisés à partir de pigments colorés en matière organique. Mais ils ont le défaut d'atténuer beaucoup la quantité de lumière reçue par les photodiodes du capteur ; un pixel recouvert d'un filtre rouge ne reçoit au maximum que 75% de la lumière reçue dans les longueurs d'onde rouges, et de la même façon un pixel recouvert d'un filtre bleu ou vert ne convertit pas uniformément toute la lumière émise dans le bleu ou dans le vert ; cela résulte de ce que la courbe de transmission du filtre en fonction de la fréquence n'est pas rectangulaire mais plutôt gaussienne et que le pic de transmission n'est pas de 100%.

Il en résulte qu'avec un faible niveau de lumière, les pixels ne sont plus assez sensibles et l'image résultante n'est pas exploitable par l'oeil.

On a proposé dans l'art antérieur de faire des matrices qui comprennent à la fois des pixels revêtus de filtres colorés, qu'on appellera ci-après pixels colorés (par exemple pixel rouge, pixel bleu, pixel vert) pour rappeler la présence du filtre coloré, et des pixels non revêtus de filtres colorés, qu'on appellera ci-après pixels blancs.

Ainsi, en cas de faible lumière, des pixels blancs recueilleront la totalité de la lumière et fourniront l'information principale de luminance. Les pixels colorés recueilleront moins de lumière et fourniront une information de chrominance. Cette information de chrominance aura une résolution plus faible qu'avec une matrice de filtres de Bayer, et un niveau de signal plus faible que le niveau des pixels blancs puisqu'elle provient de pixels recevant moins de lumière, mais c'est un inconvénient secondaire car l'information de luminance en faible lumière est plus importante que l'exactitude colorimétrique. Plus il y a de pixels blancs, plus l'information de luminance représentera fidèlement la luminance de l'image.

Un autre problème classiquement rencontré avec les mosaïques de filtres de couleur, tout particulièrement les filtres les moins coûteux qui sont faits à partir de pigments organiques, est le fait que ces filtres sont tous très transparents aux rayons en proche infrarouge, et tout particulièrement dans la bande de 750 nanomètres à 1100 nanomètres de longueur d'onde. Or le silicium est sensible à ces longueurs d'onde et génère des charges électriques en proportion du rayonnement proche infrarouge qu'il reçoit. Ces charges engendrées dans les pixels rouges, bleus ou verts, ne sont pas générées par le véritable rayonnement rouge ou bleu ou vert que le pixel reçoit. Elles engendrent donc dans ces pixels une partie de signal qui ne représente pas la colorimétrie réelle de la scène observée par le capteur. Pour que le capteur ne reçoive pas ce rayonnement infrarouge perturbant, on a proposé dans l'art antérieur de placer devant le capteur un filtre optique coupe-bande, qui laisse passer la lumière pour les longueurs d'onde visible mais qui coupe le proche infra-rouge. Un tel filtre est coûteux parce qu'il doit couper franchement l'infrarouge tout en laissant passer notamment la bande de longueur d'onde rouge.

On a proposé également de répartir dans une mosaïque classique de pixels colorés rouge, vert, bleu, des pixels supplémentaires qu'on peut appeler pixels noirs, recouverts d'un filtre coupant complètement les longueurs d'onde visible mais laissant passer l'infrarouge. Un tel filtre peut être réalisé à l'aide de pigments organiques comme les autres filtres, par exemple en superposant, à l'endroit des pixels concernés, un filtre rouge et un filtre bleu. Si on modifie une mosaïque de Bayer, un groupe de pixels individuel comprend alors un pixel rouge, un pixel bleu, deux pixels verts, et un pixel noir ; ces pixels sont proches les uns des autres et reçoivent sensiblement la même dose de rayons infrarouges issus de la scène observée. On soustrait alors des signaux produits par les pixels rouge, vert, bleu, qui sont affectés par le rayonnement infrarouge, une valeur issue du pixel noir situé immédiatement à côté et qui ne reçoit que le rayonnement infrarouge. Cette soustraction effectuée pour tous les pixels élimine l'influence néfaste du rayonnement infrarouge sur ces pixels.

Les documents EP 1 630 871 et EP 0 605 898 divulguent des capteurs matriciels comprenant des pixels colorés et des pixels infrarouges.

L'invention repose sur la remarque que les matrices comportant des pixels colorés et des pixels blancs peuvent être traitées différemment en raison du fait que la luminance produite par les rayons infrarouge et reçue par des pixels blancs lorsqu'ils existent n'est pas nécessairement gênante. En effet, le rayonnement reçu par les pixels blancs ne fausse pas la colorimétrie, et contribue au contraire à la représentation de la luminance globale d'une scène, notamment en cas de faible lumière où un niveau de signal plus important est souhaitable pour la qualité de l'image électronique.

En conséquence, l'invention propose un capteur d'image en couleurs comprenant une matrice de N pixels photosensibles actifs, chaque pixel comportant une photodiode en silicium pour fournir un signal électrique fonction des charges électriques engendrées dans la photodiode par la lumière, la matrice étant recouverte d'une mosaïque de filtres colorés disposés en correspondance avec les pixels de la matrice pour former des pixels dits pixels colorés, les filtres étant de K types différents correspondant à un nombre K de couleurs différentes au moins égal à deux, et les pixels de chaque couleur étant répartis dans la matrice, avec P pixels, P<N, dits pixels blancs, non recouverts d'un filtre de couleur et répartis dans la matrice, caractérisé en ce que les photodiodes des pixels colorés sont constituées différemment des photodiodes des pixels blancs, les photodiodes des pixels colorés ayant, pour les longueurs d'onde infrarouges, un coefficient de conversion de photons en charges électriques significativement inférieur au coefficient de conversion des photodiodes des pixels blancs pour ces mêmes longueurs d'onde.

Ainsi, sans avoir obligatoirement besoin de pixels noirs et sans avoir besoin d'utiliser un filtre global infrarouge, qui réduirait inutilement l'information de luminance donnée par les pixels blancs et qui serait coûteux, on produit une image ayant une information de luminance de bonne qualité, particulièrement en faible niveau de lumière, et une information de chrominance faiblement dégradée par le rayonnement infrarouge.

Il y a plusieurs manières possibles pour rendre les photodiodes des pixels colorés moins sensibles au rayonnement infrarouge que les photodiodes des pixels blancs. De manière générale, on sait que les longueurs d'onde les plus courtes sont celles qui pénètrent le moins dans le silicium et qu'elles génèrent donc des charges électriques à une faible profondeur (100 à 300 nanomètres pour les longueurs d'onde bleue) ; les longueurs d'onde verte et rouge pénètrent plus loin dans le silicium profondément et génèrent des charges un peu plus en profondeur (jusqu'à un micromètre typiquement) ; les longueurs d'onde infrarouge sont celles qui pénètrent le plus profondément dans le silicium et génèrent des charges jusqu'à une profondeur qui peut être nettement plus élevée (plusieurs micromètres pour l'infrarouge proche) .

On prévoit donc des moyens pour empêcher la lumière de produire des charges utiles (c'est-à-dire des charges effectivement récupérables par la photodiode pour être lues) au-delà d'une certaine profondeur à partir de laquelle pratiquement seulement des rayons infrarouges pénètrent. Pour cela, on peut soit limiter la profondeur de la zone de charge d'espace créée dans le silicium par la polarisation inverse de la photodiode, soit créer en profondeur une zone de collecte et d'évacuation des électrons générés en profondeur. Dans le premier cas, les électrons créés en profondeur hors de la zone de charge d'espace de la photodiode d'un pixel ne peuvent pas être collectés par le pixel et ne constituent donc pas des charges utiles pour le pixel ; ces électrons se recombinent en effet ailleurs que dans la zone de charge d'espace et ne migrent pas vers la cathode de la photodiode. Dans le deuxième cas, les charges sont recueillies et évacuées vers un drain et non vers la photodiode.

Dans une réalisation, les photodiodes sont formées par une jonction NP entre une région localisée dopée de type N et une couche active, dopée de type P et portée à un potentiel de référence, la couche active ayant une profondeur H au-dessous de la jonction. Les photodiodes des pixels colorés comportent une région localisée de type P+, plus dopée que la couche active dopée de type P, cette région localisée plus dopée réduisant à une valeur H' inférieure à H la profondeur de couche active de type P située directement au-dessous de la jonction et limitant à cette profondeur H' la zone de charge d'espace produite en fonctionnement par la polarisation inverse de la photodiode, et les pixels blancs ne comportant pas une telle région localisée de type P+ de sorte que leur zone de charge d'espace peut s'étendre à une profondeur supérieure à H'.

Dans une autre réalisation, avec le même type de photodiode pour les pixels blancs, on prévoit que les photodiodes des pixels recouverts de filtres de couleur comportant une région localisée enterrée de type N+, située à une profondeur H" au-dessous de la jonction, profondeur telle que la couche active située au-dessous de la région localisée enterrée reçoive principalement des rayons infrarouges mais pas ou pratiquement pas de rayonnement visible, la région localisée enterrée étant portée à un potentiel permettant de drainer les charges engendrées par le rayonnement infrarouge au-dessous de cette région.

Dans cette deuxième réalisation, il peut être souhaitable que les pixels recouverts de filtres de couleurs soient juxtaposés de sorte qu'ils se touchent par un côté ou à la rigueur par un coin pour permettre de former une continuité de liaison des régions enterrées N+ des pixels colorés, continuité allant jusqu'à un bord de la matrice. Ainsi, les couches enterrées de type N+ de tous ces pixels peuvent être reliées les unes aux autres et il est alors plus facile de relier la couche enterrée de type N+ à un potentiel positif à partir du bord de la matrice. Cela évite de prévoir des contacts de liaison à l'intérieur du pixel. Il est cependant possible aussi, même avec des pixels blancs séparant les pixels colorés, de créer une continuité de couche enterrée N+ en lui donnant une forme de grille entourant les pixels blancs sans venir au-dessous des pixels blancs et donc sans modifier significativement la constitution et le comportement de la photodiode de ces pixels blancs.

Différentes configurations de mosaïque sont possibles, une configuration avantageuse étant un arrangement de pixels avec des groupes périodiques de pixels constitués par un pixel bleu, un pixel rouge, deux pixels filtres verts et X pixels sans filtres entre deux pixels de couleur d'une même ligne ou d'une même colonne de la matrice. X est supérieur ou égal à 1 et de égal à 1, 2 ou 3.

D'autres caractéristiques et avantages de l'invention apparaîtront à la lecture de la description détaillée qui suit et qui est faite en référence aux dessins annexés dans lesquels :
- la figure 1 représente schématiquement l'organisation d'un capteur d'image électronique en couleurs comprenant une matrice de pixels à base de silicium, revêtue d'une mosaïque de filtres colorés avec des pixels sans filtre répartis dans la matrice ;
- la figure 2 représente un exemple de réponses spectrales possibles des pixels revêtus de filtres colorés ;
- la figure 3 montre un exemple de mosaïque de l'art antérieur permettant de compenser l'influence du rayonnement en proche infrarouge ;
- la figure 4 représente l'organisation d'un capteur selon l'invention ;
- la figure 5 représente une réalisation de photodiodes avec atténuation de l'influence des infrarouges sur les pixels colorés ;
- la figure 6 représente une autre réalisation selon l'invention ;
- la figure 7 représente une manière de relier les régions N+ sous les photodiodes de pixels colorés non adjacents ;
- la figure 8 représente plusieurs configurations intéressantes de la mosaïque de pixels selon l'invention ;
- la figure 9 représente des configurations incorporant en outre des pixels noirs sensibles uniquement aux rayons infrarouge.

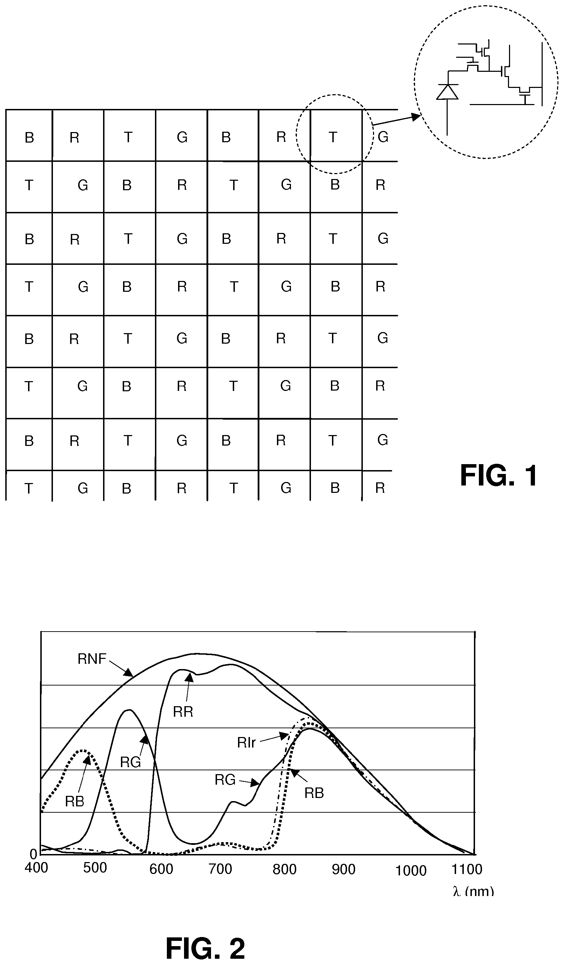

Sur la figure 1, on a représenté en vue de dessus le principe d'un capteur matriciel de l'art antérieur. Il comprend une matrice de lignes et colonnes de pixels photosensibles. Cette matrice est recouverte d'une mosaïque de filtres colorés. Dans cet exemple, il y a à la fois des pixels dits "colorés" parce qu'ils sont recouverts d'un filtre d'une couleur donnée et des pixels dits blancs qui ne sont pas recouverts d'un filtre de couleur. A titre d'exemple on a représenté une répartition régulière de groupes de quatre pixels qui sont respectivement un pixel rouge (R) recouvert d'un filtre laissant passer la lumière rouge mais pas ou peu les autres couleurs, un pixel bleu (B) recouvert d'un filtre laissant passer la lumière bleue mais pas ou peu les autres couleurs, un pixel vert (G) recouvert d'un filtre laissant passer la lumière verte mais pas ou peu les autres couleurs, et un pixel blanc (T) non recouvert d'un filtre et laissant donc passer toutes les couleurs. D'autres répartitions de couleurs dans la mosaïque existent dans l'art antérieur, y compris des répartitions avec des filtres de couleurs complémentaires cyan, magenta, jaune, à la place des couleurs primaires rouge, bleu, vert.

Le capteur est un capteur à base de silicium, qui convertit en charges électriques la lumière qu'il reçoit dans une bande de longueurs d'onde allant d'environ 300 nanomètres à environ 1100 nanomètres. Chaque pixel est constitué par une photodiode et quelques transistors fournissant un signal électrique représentant l'éclairement reçu par le pixel. Les filtres sont en général des filtres comprenant des pigments organiques colorés qui laissent passer principalement les longueurs d'onde correspondant à la couleur considérée, à savoir : environ 300 à 530 nanomètres pour le bleu, 480 à 620 nanomètres pour le vert, et environ 580 à 650 nanomètres pour le rouge.

La figure 2 représente un diagramme typique de sensibilité d'un capteur au silicium recouvert de filtres colorés organiques.

Cinq courbes différentes sont représentées sur ce diagramme. L'échelle en abscisse est graduée en longueurs d'onde ; l'échelle en ordonnée est une échelle de sensibilité en unités arbitraires, représentant le signal de sortie d'un pixel pour une quantité de photons donnée à la longueur d'onde considérée.

La courbe RNF est la courbe de réponse d'un pixel blanc, c'est-à-dire dépourvu de filtre. Elle représente la sensibilité globale intrinsèque du silicium. Elle présente un maximum dans le rouge et elle décroît de part et d'autre de ce maximum. Les autres courbes RB, RG, RR, sont les courbes de sensibilité des pixels bleus, verts, rouge respectivement, tenant compte par conséquent de la présence d'un filtre de couleur. Ces trois courbes présentent une remontée forte de la sensibilité dans le domaine infrarouge proche : au-delà d'environ 820 nanomètres, les filtres sont tous pratiquement transparents, ils n'éliminent pas ces longueurs d'onde de proche infrarouge.

Le proche infrarouge fausse donc la colorimétrie de l'image en laissant croire par exemple qu'un pixel bleu fournit un signal représentant la luminance pour les longueurs d'onde bleues, alors que le signal représente une somme d'une luminance bleue et d'une luminance infrarouge reçues sur le pixel.

Un filtre infrarouge placé devant le capteur permet d'éliminer cet inconvénient, mais il est coûteux.

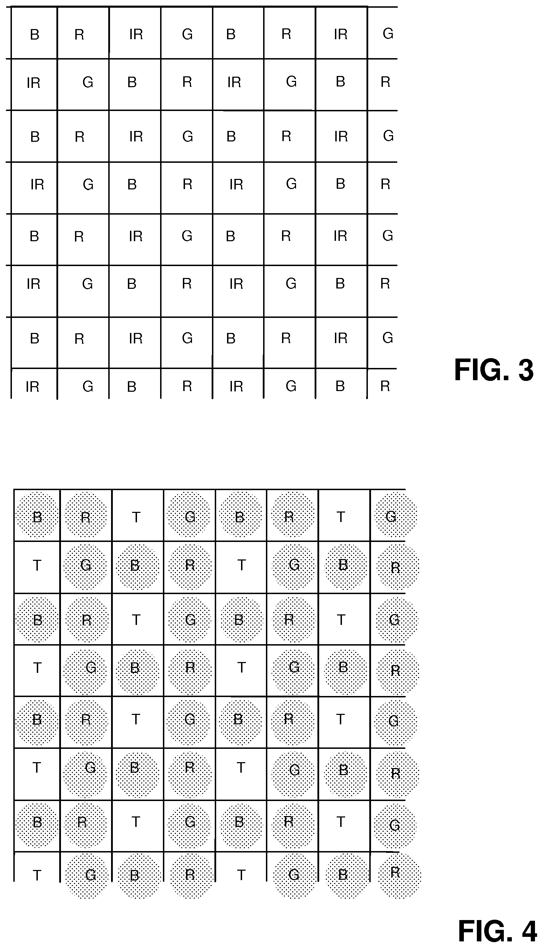

Dans l'art antérieur, on a déjà proposé des mosaïques de pixels constituées différemment, avec un pixel bleu (B), un pixel vert (G), un pixel rouge (R) et un pixel dit "noir" (IR) qui ne laisse passer aucune couleur et ne laisse passer que le rayonnement infrarouge. Un pixel noir peut être réalisé par simple superposition d'un filtre rouge et d'un filtre bleu ; sa courbe de réponse sur la figure 2 serait la courbe RIr. La figure 3 représente l'organisation d'un tel capteur. Chaque pixel coloré fournit un signal représentant la somme de la luminance reçue dans la couleur considérée et de la luminance reçue en proche infrarouge. Le pixel noir fournit un signal représentant seulement la luminance reçue en proche infrarouge. Une soustraction entre le signal issu d'un pixel coloré et le signal issu du pixel noir le plus proche élimine la composante liée à l'infrarouge dans le signal du pixel coloré.

La figure 4 représente l'organisation générale d'un capteur selon l'invention, qui repose sur un principe différent permettant d'éviter l'utilisation d'un filtre infrarouge devant le capteur et permettant d'utiliser une mosaïque de filtres comportant également des pixels blancs d'une manière qui maximise la luminance des pixels blancs. La mosaïque de filtres qui recouvre le capteur peut être la même que celle de la figure 1, c'est-à-dire qu'elle utilise des pixels (R), (G), (B) dits "colorés" parce qu'ils sont recouverts de filtres colorés, et des pixels (T) dits "blancs" qui ne sont pas recouverts de filtres colorés. On considérera dans la suite que les couleurs des filtres sont les couleurs primaires rouge vert bleu mais on pourrait alternativement prévoir des filtres de couleurs secondaires magenta, cyan, jaune.

La particularité de l'invention est le fait que les pixels colorés sont réalisés dans le silicium à partir de photodiodes qui ont une constitution différente des photodiodes des pixels blancs. Les pixels blancs ont des photodiodes qui sont assez fortement sensibles aux rayonnements infrarouge comme dans l'art antérieur, mais les pixels colorés sont faits avec des photodiodes différentes qui sont significativement moins sensibles aux rayonnements infrarouge. Les photodiodes des pixels colorés ont donc, pour les longueurs d'onde infrarouges, un coefficient de conversion (ou plus généralement un niveau de réponse en fonction de la longueur d'onde) significativement plus faible que les photodiodes des pixels blancs. Les pixels colorés R, G, B, sont représentés sur la figure 4 avec un disque à surface pointillée qui symbolise le fait que la photodiode de ces pixels est différente de la photodiode des pixels blancs. Les pixels blancs sont représentés sans ce disque à surface pointillée et ont une plus forte réponse dans le domaine infrarouge.

Les photodiodes des capteurs usuels sont en général formées par une jonction NP dans une couche active de silicium monocristallin de type P. Pour donner un coefficient de conversion dans les pixels colorés plus faible que le coefficient de conversion dans les pixels blancs, on peut par exemple limiter la profondeur de la zone de charge d'espace créée par la polarisation inverse de la photodiode, ou bien on peut créer dans la couche active une zone intermédiaire de collecte et d'évacuation des électrons générés en profondeur dans la couche active. La zone de charge d'espace, appelée aussi zone déplétée ou zone désertée, est la région dépourvue de porteurs libres qui apparaît dans une jonction N-P, en particulier lorsqu'elle est polarisée en inverse. Elle s'étend d'autant plus loin, de part et d'autre de la jonction, que la couche est moins dopée et que la tension de polarisation inverse est plus élevée. Cette zone, dans laquelle se développe un champ électrique non nul, permet un rendement de collecte des charges générées très élevé.

La jonction NP est formée entre une région localisée dopée de type N et la couche active dopée de type P. La couche active est portée à un potentiel de référence. Tous les types de conductivité pourraient être inversés sans changer la nature de l'invention et on considérera que la définition donnée pour un type de conductivité s'applique identiquement au type inverse sans sortir du cadre de l'invention.

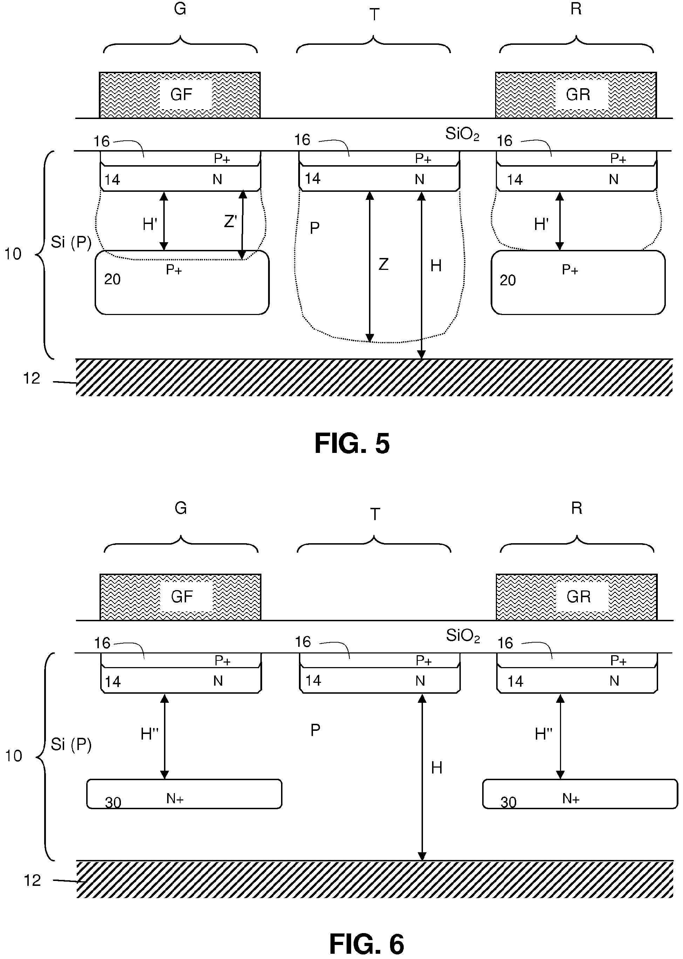

La figure 5 représente en coupe dans le silicium du capteur, les photodiodes de trois pixels adjacents. Les pixels sont deux pixels colorés rouge (R) et vert (G), et un pixel blanc (T). Seules les photodiodes sont représentées pour simplifier le schéma, les transistors des pixels n'étant pas représentés. La couche active 10 de silicium monocristallin dans laquelle sont formées les photodiodes est une couche active de type P. Elle peut être la couche supérieure d'un substrat de silicium monocristallin ou la couche épitaxiale supérieure d'un substrat SOI ("Silicon On Insulator", c'est-à-dire silicium sur isolant). Le substrat 12 est simplement représenté par des hachures sur la figure 5 ; son épaisseur est beaucoup plus grande que l'épaisseur de la couche active 10, celle-ci pouvant avoir une épaisseur de 3 micromètres à 30 micromètres.

Les photodiodes sont constituées à partir de régions individuelles 14 de type N diffusées dans la couche active 10, régions qui forment avec le silicium sous-jacent une jonction NP. De manière classique mais non obligatoirement, chaque région N 14 peut être recouverte d'une zone superficielle 16 de type P+, qui est portée à un potentiel de référence qui est le potentiel appliqué à la couche active 10. Les pixels sont des pixels actifs et comportent des transistors de lecture des charges accumulées dans les régions 14 au cours du fonctionnement. Les pixels sont séparés les uns des autres par des régions d'isolation constituées de silicium du même type que la couche active 10 mais plus dopé, l'isolation étant éventuellement renforcée par la présence de tranchées superficielles d'oxyde de silicium (isolation STI, de l'anglais "Shallow Trench Isolation"). Ces zones ne sont pas représentées ; elles empêchent ou limitent le déplacement de charges électriques générées par la lumière d'un pixel vers un pixel voisin. Enfin, une couche isolante, par exemple en oxyde de silicium SiO₂ peut recouvrir toute la surface des photodiodes.

La photodiode du pixel vert est recouverte d'un filtre vert GF et la photodiode du pixel rouge est recouverte d'un filtre rouge GR. On voit qu'il n'y a pas de filtre au-dessus de la photodiode du pixel blanc T.

Ce qu'on appellera photodiode dans cette description est l'ensemble de la région N 14 (avec éventuellement sa région 16) et les régions semiconductrices situées sous la région 14.

Dans la réalisation de la figure 5, la différence de constitution des photodiodes des pixels colorés et des pixels blancs est une différence qui provoque une différence dans les possibilités d'extension en profondeur de la zone de charge d'espace créée dans la couche active par la polarisation inverse de la photodiode. Les possibilités d'extension de la zone de charge d'espace (figurée par un trait pointillé) sont plus limitées dans les pixels colorés, grâce à la constitution particulière de la photodiode de ces pixels, que dans les pixels blancs. Cette extension dépend du dopage du semiconducteur au-dessous de la jonction et dépend de la tension de polarisation inverse de la photodiode. Mais on établit une limite d'extension dans les pixels colorés, plus faible que dans les pixels blancs, grâce à une couche profonde de type P+ plus dopée que la couche active.

Dans l'exemple donné sur la figure 5, on considère que la profondeur H de la couche active est de 3 à 10 micromètres environ et que la zone de charge d'espace occupe toute la profondeur ou pratiquement toute la profondeur de la couche active au-dessous des pixels blancs. On pourrait cependant avoir une profondeur H de couche active différente de la profondeur Z de la zone de charge d'espace, en particulier lorsque la profondeur de la couche active est supérieure à 10 ou 20 micromètres, voire plus.

On prévoit alors au-dessous des pixels colorés une région localisée 20 de même type de conductivité que la couche active mais plus dopée, limitant à une profondeur Z' au-dessous de la jonction NP, l'extension de la zone de charge d'espace produite en fonctionnement par la polarisation inverse de la photodiode du pixel. La profondeur Z' est inférieure à Z et en pratique le haut de la région localisée P+ peut-être situé à une profondeur H'=Z' au-dessous de la jonction, ou un peu au-dessus de cette profondeur si la région localisée P+ est beaucoup plus dopée que la couche active. En effet, la zone de charge d'espace s'étend très peu dans une région fortement dopée. L'extension de la zone de charge d'espace est proportionnelle à la racine carrée de l'inverse de la concentration en atomes dopants.

Les rayonnements de longueurs d'onde visibles bleu, vert, rouge, pénètrent dans le silicium et créent des charges électriques dans la profondeur Z'. Ils ne pénètrent pas plus profondément ou pas beaucoup plus profondément. Les rayons infrarouge pénètrent plus profondément, dans la région P+ 20 et au-delà. S'ils créent des charges électriques dans la région P+, ces charges se recombinent rapidement et les électrons ne sont pas attirés vers la région N de la photodiode. S'ils créent des charges entre la région P+ 20 et le substrat 12, ces charges peuvent éventuellement se disperser vers les pixels blancs voisins, mais pas vers les pixels colorés à cause des régions P+ 20 qui gênent leur passage vers les régions 14.

Les photodiodes des pixels blancs ne possèdent pas cette région P+. Les rayonnements de longueurs d'onde visible ou proche infrarouge créent des charges électriques dans toute la profondeur Z de la zone de charge d'espace, ici pratiquement dans toute la profondeur de la couche active. Les électrons drainés par le champ électrique présent dans la zone de charge d'espace peuvent être collectés par la région N 14 du pixel blanc. Toute la luminance reçue contribue, quelle que soit la longueur d'onde, au signal produit par le pixel blanc. Celui-ci donne une indication de luminance la meilleure possible. Le risque de réception d'électrons issus de rayons infrarouges venant de pixels colorés voisins existe, engendrant un risque de perte de résolution de la luminance, mais ce risque est d'autant plus faible que le rapport entre le nombre de pixels colorés et le nombre de pixels blancs est plus faible. On verra plus loin des configurations dans lesquels, pour obtenir une bonne résolution de luminance, on prévoit beaucoup plus de pixels blancs que de pixels colorés.

Ainsi, on a réalisé comme on le souhaitait une matrice dans laquelle le coefficient de conversion de photons en signal utile pour les longueurs d'onde infrarouges est plus faible pour les photodiodes des pixels revêtus de filtres colorés que pour les photodiodes des pixels blancs.

Typiquement, la profondeur Z' peut être comprise entre 1 à 5 micromètres, de préférence entre 1 et 3 micromètres, la différence de hauteur Z-Z' étant de préférence supérieure à 2 micromètres et pouvant même être de 10 à 20 micromètres dans le cas où la couche active est constituée simplement par la partie supérieure d'un substrat de silicium monocristallin. La profondeur H' peut être égale à Z'. La profondeur H est au moins égale à Z mais peut être largement supérieure dans certains cas.

Le dopage de la région localisée de type P+ 20 (typiquement 1 à 10 fois 10¹⁶ atomes/cm³, correspondant à une résistivité de quelques ohms-cm) est de préférence au moins 10 fois et de préférence au moins 100 fois supérieur au dopage de la couche active de type P (typiquement de 1 à 10 fois 10¹⁴ atomes/cm³, correspondant à une résistivité de quelques dizaines d'ohms-cm) de sorte que la zone de charge d'espace s'arrête pratiquement à la profondeur H' en haut de la région P+ 20 en pénétrant très peu dans la région P+.

La région dopée de type P+ peut être réalisée par implantation profonde d'impuretés du même type que les impuretés qui dopent la couche active, de préférence du bore. Cette implantation a lieu avant les implantations des régions 14 et 16 des photodiodes.

La figure 6 représente un autre exemple de réalisation aboutissant au même résultat souhaité, à savoir à une réponse des photodiodes à une longueur d'onde infrarouge (la réponse étant la quantité de charges électriques engendrées par une quantité de photons à une longueur d'onde donnée et effectivement récupérées par la photodiode pour fournir un signal utile pour cette longueur d'onde) qui est plus faible pour les pixels colorés que pour les pixels blancs, et ceci de la même manière pour tous les pixels colorés.

Dans cette réalisation, on prévoit dans les photodiodes des pixels colorés non pas une région P+ qui limite la profondeur de la zone de charge d'espace mais une région localisée 30 de type N+, située à une profondeur H", et portée à un potentiel positif permettant de drainer les électrons qui sont engendrés par la lumière à une profondeur dans laquelle ce sont essentiellement les rayons infrarouges et non pas les rayonnements visibles qui engendrent des paires électrons-trous. Cette région N+ 30 est portée à un potentiel fixe qui peut être l'alimentation générale Vdd ou un potentiel plus faible mais supérieur au potentiel de référence de la couche active. Les électrons sont évacués vers ce potentiel fixe.

Les photons résultant de la lumière visible sont absorbés dans le silicium à une profondeur plus faible que la profondeur H" de la région N+ et créent des électrons qui sont drainés comme dans les photodiodes des pixels blancs vers la région N de la photodiode pour fournir un signal utile. Les photons infrarouges absorbés à proximité de la région N+ 30 ou dans la région N+ 30 ou au-dessous de la région N+ 30 sont évacués et ne fournissent pas de signal utile.

Les photodiodes des pixels blancs ne comportent pas cette région N+ 30.

Il en résulte là encore une réponse électrique pour les longueurs d'onde infrarouges plus faible dans les pixels colorés que dans les pixels blancs.

Pour réaliser les régions N+ profondes, on peut partir d'un substrat comportant une couche active épitaxiale de type P d'épaisseur H-H" plus faible que l'épaisseur finale souhaitée, c'est-à-dire plus faible que la somme de la profondeur H et de la profondeur des zones 14 et 16. On réalise un masque qui protège les surfaces correspondant aux emplacements des photodiodes des pixels blancs et on implante à la surface de cette couche partielle les zones N+ 30 désirées sous les pixels qui seront recouverts de filtres colorés. Puis on continue la croissance épitaxiale de toute la hauteur de couche active souhaitée avant de former les régions N et P+ des photodiodes.

Pour éviter de faire un contact de connexion de la couche N+ dans chaque pixel coloré (pour une liaison au potentiel fixe de drainage), on prévoit de préférence que toutes les régions N+ 30 sont reliées les unes aux autres, et on fait un contact uniquement sur un ou plusieurs bords extérieurs de la matrice. C'est tout-à-fait possible dans le cas de la figure 4, en faisant en sorte que la région N+ 30 d'un pixel coloré s'étend jusqu'à toucher la région d'un pixel coloré adjacent.

C'est possible également de le faire dans tous les cas où les pixels se touchent par un côté, ou même seulement par un coin en faisant se toucher les régions N+ sur deux côtés adjacents ou deux coins adjacents.

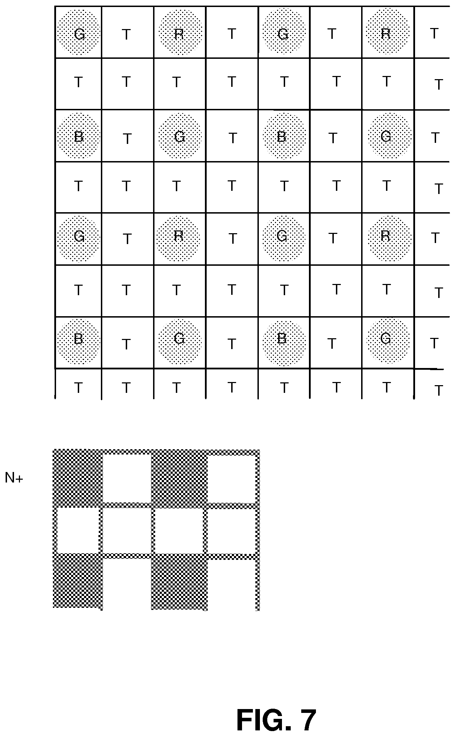

De plus, même si les pixels colorés ne forment pas une continuité de bords ou de coins allant jusqu'à un bord de la matrice, on peut encore faire une continuité de régions N+ sous forme d'une grille dont les ouvertures sont situées à l'endroit des pixels blancs seulement, comme représenté à titre d'exemple sur la figure 7. Dans cet exemple (utilisable aussi dans la réalisation de la figure 5), les pixels sont organisés par motifs élémentaires de seize pixels comprenant un pixel rouge, un pixel bleu, deux pixels verts, et douze pixels blancs. Les pixels colorés sont tous séparés les uns des autres par un pixel blanc et leurs coins ne se touchent pas. On peut alors faire une grille de régions N+ comme indiqué sur la figure 7 au-dessous de la mosaïque représentée ; cette grille comporte des surfaces de zones N+ continues au-dessous des pixels colorés G, R, B, des surfaces ouvertes au-dessous des pixels blancs T, et des liaisons autour des pixels blancs, liaisons suffisamment étroites qui ne perturbent pratiquement pas les pixels blancs.

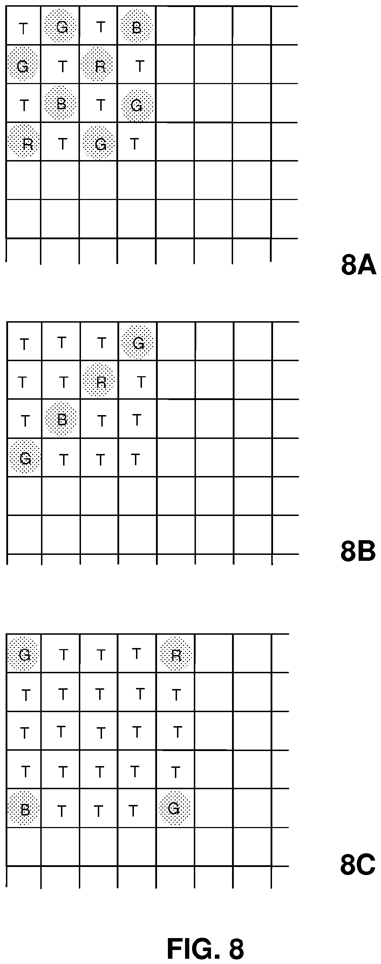

La figure 8 représente différents autres arrangements de pixels colorés et blancs correspondant à des proportions différentes de pixels colorés (50%, 25% et 6% respectivement). Plus il y a de pixels colorés meilleure est la colorimétrie. Plus il y a de pixels blancs, meilleure est la résolution de l'image en luminance. La mosaïque 8A comprend une répétition périodique de carrés de 16 pixels avec 8 pixels blancs, quatre pixels verts, deux pixels rouge et deux pixels bleus. La mosaïque 8B comprend un motif périodique de carrés de seize pixels avec douze pixels blancs et quatre pixels colorés (deux verts, un rouge, un bleu, alignés selon une diagonale du carré). La mosaïque 8C comprend des carrés périodiques de 25 pixels dont quatre pixels colorés (deux verts, un rouge et un bleu) et 21 pixels blancs, offrant une très bonne résolution en luminance.

Dans une variante de réalisation, on prévoit dans la mosaïque de filtres colorés une répartition de pixels noirs recouverts chacun d'un filtre laissant passer l'infrarouge proche et ne laissant pas passer la lumière visible. Ces pixels noirs sont réalisés avec des photodiodes identiques aux photodiodes des pixels colorés, c'est-à-dire atténuant l'influence des rayons infrarouge proche de la même manière que pour les pixels colorés. On recueille le signal issu de chaque pixel coloré et le signal issu du pixel noir le plus proche (ou une interpolation de signaux issus des pixels noirs les plus proches), et on soustrait ce signal du signal issu du pixel coloré. Mais on n'effectue pas de soustraction entre le signal issu des pixels blancs et les signaux issus des pixels noirs. Ce traitement de signal permet ainsi d'améliorer la colorimétrie des pixels de couleur sans détériorer la sensibilité des pixels blancs. Il peut être mis en œuvre en pratique dans le capteur ou par un circuit externe de traitement de signal recevant les signaux recueillis pour chacun des pixels de la matrice.

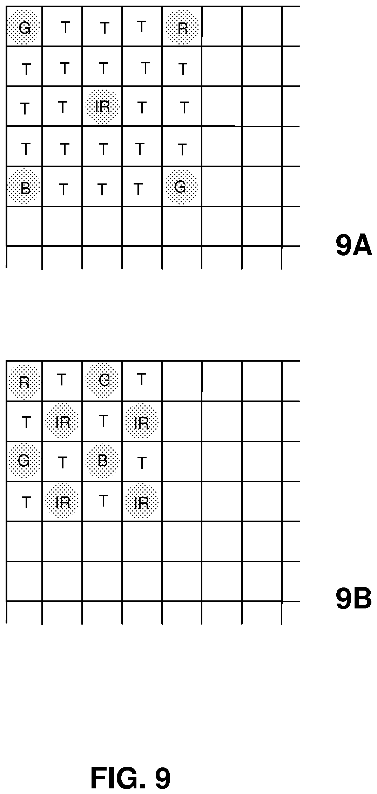

La figure 9 représente deux exemples de réalisation de cette variante. Le premier exemple (9A) est tiré de celui de la figure 8C, dans lequel on a remplacé le pixel central blanc par un pixel noir IR. Du point de vue de la présente invention, le pixel noir est considéré comme un pixel coloré, revêtu d'un filtre infrarouge qui peut être réalisé par la combinaison (superposition ou mélange de pigments) d'un filtre rouge et d'un filtre bleu. Le deuxième exemple (9B) comprend une plus grande proportion de pixels noirs, le motif élémentaire répété dans la mosaïque comportant huit pixels blancs, quatre pixels colorés, et quatre pixels noirs, chaque pixel noir étant à équidistance de quatre pixels colorés.

Pour terminer cette description, on indique qu'on a appelé N et P les types de conductivité correspondant habituellement à des atomes d'impuretés donneurs ou accepteurs d'électrons, mais étant donné que les types de conductivité peuvent être tous inversés sans changer en rien les principes de l'invention, on considère pour les besoins de cette description et des revendications que les appellations N et P sont purement conventionnelles et peuvent désigner des dopages contraires à l'usage habituel. Les charges électriques récupérées ne sont alors plus des trous et les sens des différences de potentiel doivent être inversés. Cette notation évite d'alourdir le langage par des expressions telles que "premier type de conductivité", "second type de conductivité", "charges électriques positives", "charges électriques négatives", etc..

## Revendications

1. Capteur d'images en couleurs, comprenant une matrice de N pixels photosensibles actifs, chaque pixel comportant une photodiode pour fournir un signal électrique en fonction des charges électriques engendrées dans la photodiode par la lumière, la matrice étant recouverte d'une mosaïque de filtres colorés (GF, GR) disposés en correspondance avec la matrice de pixels pour former des pixels dits pixels colorés (R, G, B) revêtus d'un filtre coloré, les filtres étant de K types différents correspondant à un nombre K de couleurs différentes au moins égal à deux et les pixels de chaque couleur étant répartis dans la matrice, la matrice comprenant en outre P pixels, P<N, dits pixels blancs (T), répartis dans la matrice, les photodiodes des pixels colorés étant constituées différemment des photodiodes des pixels blancs, les photodiodes des pixels colorés ayant, pour les longueurs d'onde infrarouges, un coefficient de conversion de photons en charges électriques significativement inférieur au coefficient de conversion des photodiodes des pixels blancs pour ces mêmes longueurs d'onde,
**caractérisé en ce que** la photodiode est une photodiode en silicium et **en ce que** les pixels blancs sont non recouverts d'un filtre de couleur.

2. Capteur d'images en couleurs selon la revendication 1, dans lequel les photodiodes sont formées par une jonction NP entre une région localisée (14) dopée de type N et une couche active (10), dopée de type P et portée à un potentiel de référence, la couche active ayant une profondeur H au-dessous de la jonction, les photodiodes des pixels colorés comportant une région localisée (20) de type P+, plus dopée que la couche active, cette région localisée plus dopée réduisant à une valeur H' inférieure à H la profondeur de couche active de type P située directement au-dessous de la jonction et limitant à cette profondeur H' la zone de charge d'espace produite en fonctionnement par la polarisation inverse de la photodiode, et les pixels blancs ne comportant pas une telle région localisée de type P+ de sorte que leur zone de charge d'espace peut s'étendre à une profondeur supérieure à H'.

3. Capteur d'image en couleurs selon la revendication 2, dans lequel la profondeur H' est comprise entre 2 et 3 micromètres et la différence de profondeur H-H' est supérieure à 2 micromètres.

4. Capteur d'image en couleurs selon l'une des revendications 2 et 3, dans lequel le dopage de la région localisée de type P+ est au moins 10 fois et de préférence au moins 100 fois supérieur au dopage de la couche active de type P.

5. Capteur d'images en couleurs selon la revendication 1, dans lequel les photodiodes sont formées par une jonction NP entre une région localisée (14) dopée de type N et une couche active (10), dopée de type P et portée à un potentiel de référence, la couche active ayant une profondeur H au-dessous de la jonction, les photodiodes des pixels recouverts de filtres de couleur comportant une région localisée enterrée (30) de type N+, située à une profondeur H" au-dessous de la jonction, profondeur telle que la couche active située au-dessous de la région localisée enterrée reçoive principalement des rayons infrarouges mais pratiquement pas de rayonnement visible, la région localisée enterrée étant portée à un potentiel permettant de drainer les charges engendrées par le rayonnement infrarouge au-dessous de cette région, et les photodiodes des pixels non recouverts de filtres de couleur ne comportant pas une telle région localisée enterrée de type N.

6. Capteur d'images en couleurs selon la revendication 5, dans lequel la profondeur H" de la région localisée enterrée de type N+ est d'au moins 3 micromètres.

7. Capteur d'images en couleurs selon l'une des revendications 5 et 6, dans lequel les pixels colorés sont agencés en série de sorte qu'ils se touchent par un coin ou par un côté et les régions N+ enterrées localisées forment une continuité de dopage N+ allant jusqu'à un bord de la matrice.

8. Capteur d'images en couleur selon l'une des revendications précédentes, dans lequel la matrice comporte un arrangement de pixels avec des filtres de trois couleurs différentes, notamment un arrangement périodique de groupes de pixels comportant un filtre bleu, un filtre rouge, deux filtres verts et X (X >= 1) pixels blancs entre deux pixels colorés d'une même ligne ou d'une même colonne de la matrice.

9. Capteur d'images en couleur selon la revendication 8, dans lequel X est égal à 1 ou 2 ou 3.

10. Capteur d'images en couleur selon l'une des revendications précédentes, **caractérisé en ce que** la matrice de pixels comporte des pixels dits noirs laissant passer les rayons infrarouges mais pas la lumière visible, répartis dans la matrice, les photodiodes de ces pixels étant constituées comme les photodiodes des pixels colorés.

## Patentansprüche

1. Farbbildsensor mit einer Matrix aus N aktiven lichtempfindlichen Pixeln, wobei jedes Pixel eine Photodiode zum Liefern eines elektrischen Signals in Abhängigkeit von den in der Photodiode durch das Licht erzeugten elektrischen Ladungen aufweist, wobei die Matrix mit einem Mosaik aus Farbfiltern (GF, GR) bedeckt ist, die in Übereinstimmung mit der Pixelmatrix angeordnet sind, um farbige Pixel (R, G, B) genannte Pixel zu bilden, die mit einem Farbfilter beschichtet sind, wobei die Filter von K verschiedenen Typen sind, die einer Anzahl K von verschiedenen Farben entsprechen, die mindestens gleich zwei ist, und die Pixel jeder Farbe in der Matrix verteilt sind, wobei die Matrix außerdem in der Matrix verteilte P Pixel, P<N, weiße Pixel (T) genannt, umfasst, wobei die Photodioden der farbigen Pixel anders als die Photodioden der weißen Pixel konstituiert sind, wobei die Photodioden der farbigen Pixel für die Infrarot-Wellenlängen einen Umwandlungskoeffizienten von Photonen in elektrische Ladungen aufweisen, der signifikant niedriger ist als der Umwandlungskoeffizient der Photodioden der weißen Pixel für dieselben Wellenlängen,
**dadurch gekennzeichnet, dass** die Fotodiode eine Silicium-Fotodiode ist, und dadurch, dass die weißen Pixel nicht mit einem Farbfilter bedeckt sind.

2. Farbbildsensor nach Anspruch 1, wobei die Fotodioden durch einen NP-Übergang zwischen einer N-dotierten lokalisierten Region (14) und einer P-dotierten aktiven Schicht (10) gebildet werden, die auf einem Bezugspotential ist, wobei die aktive Schicht eine Tiefe H unter dem Übergang aufweist, wobei die Photodioden der farbigen Pixel eine lokalisierte Region (20) des Typs P⁺ umfassen, die stärker dotiert ist als die aktive Schicht, wobei diese stärker dotierte lokalisierte Region die Tiefe der aktiven Schicht vom Typ P, die sich direkt unter dem Übergang befindet, auf einen Wert H' verringert, der kleiner ist als H, und die Raumladungszone, die im Betrieb durch die Umkehrpolarisation der Photodiode erzeugt wird, auf diese Tiefe H' begrenzt, und wobei die weißen Pixel keine solche lokalisierte Region vom Typ P⁺ umfassen, so dass sich ihre Raumladungszone auf eine Tiefe erstrecken kann, die größer ist als H'.

3. Farbbildsensor nach Anspruch 2, wobei die Tiefe H' zwischen 2 und 3 Mikrometern liegt und die Tiefendifferenz H-H' größer als 2 Mikrometer ist.

4. Farbbildsensor nach einem der Ansprüche 2 und 3, wobei die Dotierung der lokalisierten Region des Typs P⁺ mindestens 10-mal und vorzugsweise mindestens 100-mal größer ist als die Dotierung der aktiven Schicht vom Typ P.

5. Farbbildsensor nach Anspruch 1, wobei die Photodioden durch einen NP-Übergang zwischen einer N-dotierten lokalisierten Region (14) und einer P-dotierten aktiven Schicht (10) gebildet werden, die auf ein Bezugspotential gebracht wird, wobei die aktive Schicht eine Tiefe H unter dem Übergang aufweist, wobei die Photodioden der mit Farbfiltern bedeckten Pixel eine vergrabene lokalisierte Region (30) des Typs N⁺ in einer solchen Tiefe H" unter dem Übergang aufweisen, dass die aktive Schicht unter der vergrabenen lokalisierten Region hauptsächlich Infrarotstrahlung, aber praktisch keine sichtbare Strahlung empfängt, wobei die vergrabene lokalisierte Region auf ein Potential gebracht wird, das es zulässt, die durch die Infrarotstrahlung erzeugten Ladungen unter dieser Region abzuleiten, und die Photodioden der nicht mit Farbfiltern bedeckten Pixel keine solche vergrabene lokalisierte Region des N-Typs aufweisen.

6. Farbbildsensor nach Anspruch 5, wobei die Tiefe H" der lokalisierten vergrabenen Region vom Typ N⁺ mindestens 3 Mikrometer beträgt.

7. Farbbildsensor nach einem der Ansprüche 5 und 6, wobei die farbigen Pixel in Reihe angeordnet sind, so dass sie sich an einer Ecke oder einer Kante berühren und die lokalisierten vergrabenen N⁺ Regionen ein N⁺ Dotierungskontinuum bilden, das sich bis zu einer Kante der Matrix erstreckt.

8. Farbbildsensor nach einem der vorherigen Ansprüche, wobei die Matrix eine Anordnung von Pixeln mit Filtern dreier verschiedener Farben aufweist, insbesondere eine periodische Anordnung von Pixelgruppen mit einem Blaufilter, einem Rotfilter, zwei Grünfiltern und X (X >= 1) weißen Pixeln zwischen zwei farbigen Pixeln einer selben Zeile oder einer selben Spalte der Matrix.

9. Farbbildsensor nach Anspruch 8, wobei X 1 oder 2 oder 3 ist.

10. Farbbildsensor nach einem der vorherigen Ansprüche, **dadurch gekennzeichnet, dass** die Pixelmatrix schwarz genannte Pixel umfasst, die Infrarotstrahlen durchlassen, sichtbare Strahlen aber nicht, die in der Matrix verteilt sind, wobei die Fotodioden dieser Pixel wie die Fotodioden der farbigen Pixel konstituiert sind.

## Claims

1. A colour-image sensor, comprising a matrix of N active photosensitive pixels, each pixel having a photodiode in order to deliver an electrical signal as a function of the electrical charges generated in the photodiode by light, the matrix being covered with a mosaic of colour filters (GF, GR) placed in correspondence with the matrix of pixels to form pixels that are referred to as coloured pixels (R, G, B) coated with a colour filter, the filters being of K different types corresponding to a number K of different colours at least equal to two and the pixels of each colour being distributed in the matrix, the matrix further comprising P pixels, with P<N, that are referred to as white pixels (T), distributed in the matrix, the photodiodes of the coloured pixels being constructed differently from the photodiodes of the white pixels, the photodiodes of the coloured pixels having, for infrared wavelengths, a coefficient of conversion of photons into electrical charges significantly lower than the conversion coefficient of the photodiodes of the white pixels for the same wavelengths,
**characterized in that** the photodiode is a silicon photodiode and **in that** the white pixels are not covered with a colour filter.

2. The colour-image sensor according to claim 1, wherein the photodiodes are formed by an NP junction between an N-type doped localized region (14) and a p-type doped active layer (10) and that is brought to a reference potential, the active layer having a depth H below the junction, the photodiodes of the coloured pixels having a P⁺-type localized region (20) that is more highly doped than the active layer, this more highly doped localized region decreasing to a value H' lower than H the depth of P-type active layer located directly below the junction and limiting to this depth H' the space-charge zone produced in operation by reverse biasing of the photodiode, and the white pixels not having such a P⁺-type localized region so that their space-charge zone may extend to a depth greater than H'.

3. The colour-image sensor according to claim 2, wherein the depth H' is comprised between 2 and 3 microns and the depth difference H- H' is greater than 2 microns.

4. The colour-image sensor according to one of claims 2 and 3, wherein the doping of the P⁺-type localized region is at least 10 times and preferably at least 100 times greater than the doping of the P-type active layer.

5. The colour-image sensor according to claim 1, wherein the photodiodes are formed by an NP junction between a n-type doped localized region (14) and a P-type doped active layer (10) and that is brought to a reference potential, the active layer having a depth H below the junction, the photodiodes of the pixels covered with colour filters having an N⁺-type buried localized region (30) located at a depth H" below the junction, which depth is such that the active layer located below the buried localized region mainly receives infrared rays, but virtually no visible radiation, the buried localized region being brought to a potential allowing the charges generated by infrared radiation below this region to be drained, and the photodiodes of the pixels not covered with colour filters not having such an N-type buried localized region.

6. The colour-image sensor according to claim 5, wherein the depth H" of the N⁺-type buried localized region is at least 3 microns.

7. The colour-image sensor according to one of claims 5 and 6, wherein the coloured pixels are arranged in series so that they touch via one corner or via one side and the localized buried N⁺ regions form an N⁺ doping continuity extending as far as one edge of the matrix.

8. The colour-image sensor according to one of the preceding claims, wherein the matrix has an arrangement of pixels with filters of three different colours, especially a periodic arrangement of groups of pixels having a blue filter, a red filter and two green filters, and X (X >= 1) white pixels between two coloured pixels of a given row or of a given column of the matrix.

9. The colour-image sensor according to claim 8, wherein X is equal to 1 or 2 or 3.

10. The colour-image sensor according to one of the preceding claims, **characterized in that** the matrix of pixels has pixels that are called black pixels letting infrared rays, but not visible light, pass, said black pixels being distributed in the matrix, the photodiodes of these pixels being formed like the photodiodes of the coloured pixels.
